# EUROPEAN PATENT SPECIFICATION

(11) **EP 0 350 179 B1**
(45) Date of publication and mention of the grant of the patent: **19.01.1994**
(21) Application number: 89306256.2
(22) Date of filing: 21.06.1989
(51) Int. Cl.: G06K 19/06, B29C 67/24

(54) **Manufacturing portable electronic tokens**
Herstellung von tragbaren elektronischen Karten
Fabrication des cartes électroniques portables

(30) Priority: 21.06.1988 GB 8814664; 19.01.1989 GB 8901189
(43) Date of publication of application: 10.01.1990
(73) Proprietor: GEC AVERY LIMITED, Warley, West Midlands, B66 2LP (GB)
(72) Inventor: Jarvis, Charles Richard, Tiptree Essex (GB)
(74) Representative: Elliott, Frank Edward

(56) References cited:
- EP-A- 0 041 642
- EP-A- 0 071 255
- EP-A- 0 134 820
- EP-A- 0 246 744
- GB-A- 588 658
- GB-A- 2 081 974
- US-A- 4 214 936
- RESEARCH DISCLOSURE, no. 290, June 1988, page 418, abstract no. 29089, New York, NY, US; "Integrated circuit encapsulation by reaction injection molding"
- IBM TECHNICAL DISCLOSURE BULLETIN, vol. 28, no. 11, April 1986, pages 4723-4725, New York, US; "Stiffened card with integrated circuit"

## Description

This invention relates to manufacturing portable electronic tokens and in particular, but not exclusively, it relates to the manufacture of small, portable, articles which include an electronic circuit encapsulated within a plastics material, such as an electronic token of the "smart card" type.

Injection moulding is often used as a method of manufacturing small plastic articles. In such methods, usually small granules of the plastics material are heated so as to melt the material and the resulting fluid is injected at high temperature and pressure, perhaps 300°C and 2,00 PSI (1 PSI ≈ 6895 Pa) into a mould of a desired shape. The material is then allowed to set in the mould as it cools.

Such a method is fine for the manufacture of small, homogeneous, articles. However, articles such as those commonly known as "smart cards" which comprises a number of components such as electronic circuits, input/output interfaces, substrates and labels are less well suited to the process since the high pressures and temperatures involved tend to displace inserts and indeed can damage the functioning thereof.

Research Disclosure, No. 290, June 1988, page 418, abstract No. 29089, New York, NY, US; entitled "Integrated circuit encapsulation by reaction injection moulding" describes a moulding process for the encapsulation of in line tape automatic bonded products such as IC's wherein individual IC's are packaged by encapsulation in plastics material.

Smart cards are generally manufactured by a lamination process. The present invention seeks to provide an improved moulding technique for articles of this kind.

According to the present invention, there is provided a method of manufacturing portable electronic tokens such as smart cards, each token comprising one or more electronic components and data input/output means encapsulated within a plastics body and having high tensile modulus members disposed as skins on at least two opposing main faces of the body and having graphics thereon; which method comprises locating two high tensile members against respective sides of a mould, locating the components and data input/output means between the members, injecting a reaction injection mouldable plastics material into the mould such that it encapsulates the components and input/output means and thus forms the plastics body of the token but is prevented, by the members, from contacting the surfaces of the mould, allowing the material to harden, and, removing the token from the mould.

Preferably, the articles are electronic tokens of the "smart card" type and have credit card sized dimensions, typically 8.5 by 5.4 by 0.075 cm. They may be of the type which use contactless coupling by means of an inductive loop, encapsulated within the plastics or resin material. In one embodiment, the portions of the token are co-extruded. The mould may comprise two endless belts which are located to cooperate in use to form a continuously moving mould cavity.

In an alternative embodiment, the high tensile members are arranged in two continuous sheets and are transported through the moulds, carrying the components and plastics material; the individual tokens being subsequently separated after hardening.

Preferably, after the components and plastics material have been introduced between the members, the edges of the members are sealed to form a sealed structure within which the plastics material is allowed to harden. To protect the graphics on the labels or skins, the graphics may be printed or otherwise deposited on their inner surface, i.e. the surface contacting the plastics material. The provision of the skins serves both to strengthen a card, as the skin is of a sufficiently high tensile modulus as to make a card substantially rigid but flexible, typically of similar flexibility and rigidity to a standard laminated credit card, and also serves as a mould release agent since the plastics material, which may for example be an epoxy, has an adhesive nature and thus problems can arise if this contacts the mould and adheres to it.

Any plastics material or mixture may be used which has the capability of hardening under a reaction injection moulding (RIM) process.

An embodiment of the invention will now be described by way of example only with reference to the accompanying Figures in which;
Figure 1 shows schematically the cross section of an electronic token when manufactured by a method embodying the present invention, and;
Figures 2 and 3 show schematically manufacturing processes.

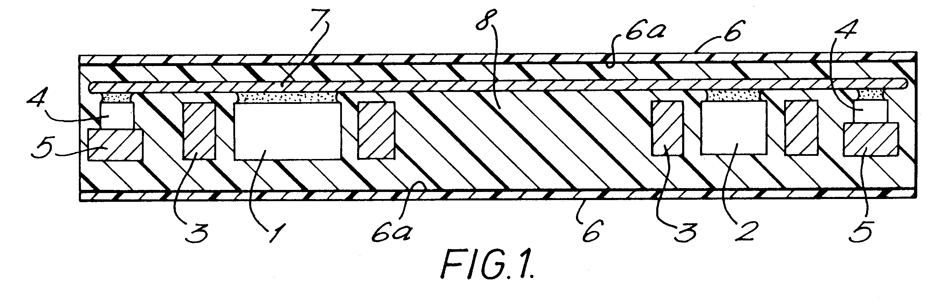

Referring to Figure 1, the token or card incorporates one or more integrated circuits 1 and capacitors 2. Rigid inserts 3, which may be made of strong metal or a rigid moulded compound, surround the circuits and capacitors so as to provide strengthening and to resist damage caused by flexing the card. The power and input/output requirements of such a card are achieved by means of inductive coils 4 mounted on a substrate 5 and disposed generally around the periphery of the card. Printed labels 6 are positioned on the face of the card. These labels are made of polyester, polycarbonate, polyimide or a material of a similar tensile modulus and, in addition to their function as labels, also have a strengthening effect due to a 'double-skinned' effect. Without the labels the cards might be flaccid and their functions would probably be impaired. The printing is preferably on the inner surface 6a of the label to protect it. The electronic components within the card are inter-connected by means of for example copper layers 7. The remainder of the material of the card is made from a moulded plastics or resin material such as polyurethane 8 or epoxy.

The card is assembled by means of a moulding process known as reaction injection moulding (RIM). This is a well known process which is often used in the manufacture of large plastics articles such as car bumpers, surfboards and the like. The difference from conventional injection moulding techniques is that two materials are used which are combined immediately before moulding. These are a resin and a hardener which, when combined together harden within a fixed time period which is dependent upon the constituents. With conventional injection moulding, heat and pressure are required to melt the resin and inject it into a mould, whereupon the resin sets as it cools. RIM is characterised by the fact that since the resin and hardener mixture is a liquid at a low temperature then high pressure and temperatures are not required.

In a first embodiment of the present invention the components of the card, other than the liquid plastics material are fixed in place within a mould such that the labels are adjacent the sides of the mould, printed surface inward, and the other components lie between the labels. The resin is then added at a low pressure and temperature. Since the resin is in a fluid state, typically having the consistency of for example milk or thin cream, then the resin flows throughout the mould, making good contact with all the components and eventually completely covering and encapsulating them. It then begins to set after the fixed time period, perhaps two to ten minutes, although resins are available which can begin to set after a few seconds. After the resin has set then the complete token is removed from the mould and the process can be repeated.

Since the resin is not allowed to contact the mould walls the labels act as a release from the mould cavity walls.

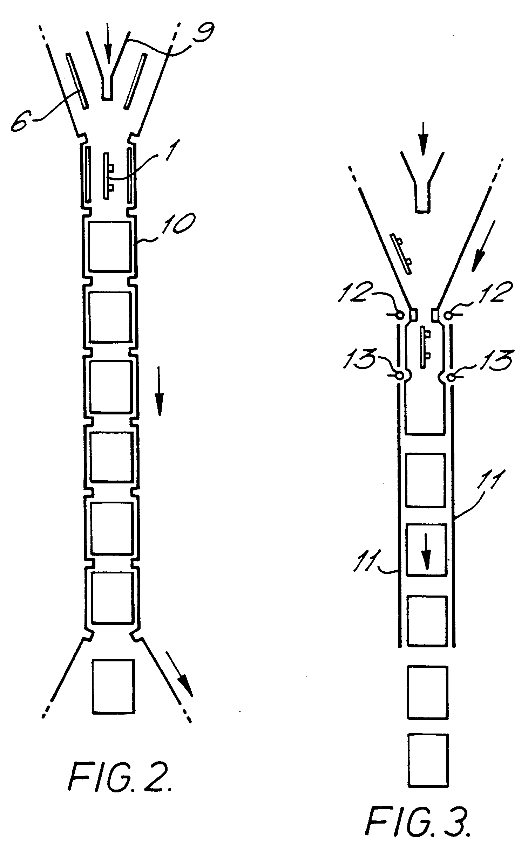

In order to speed up the production rate, the preprinted labels and components can be fed into a die which is also supplied with RIM fluid resin from a nozzle. This is shown in Figure 2 (which is not to scale), in which the die consists of two recessed endless belts running back to back to form a continuously moving mould cavity or a plurality of cavities 10, as shown, moving in the direction shown by the arrows. The labels 6 and components 1 are fed into the or each moving cavity and the resin fed in through a nozzle 9 the resin setting and hardening in the mould cavity or cavities as the belts move. The components, labels and fluid, in the required configuration, are then coextruded from the die to form continuous strips of completed cards, which subsequently set and are then separated as desired.

Figure 3 shows an alternative process in which the labels 6 are arranged in two continuous sheets which are spooled through a mould 11. The edges of the continuous sheets are sealed together by pinch rollers. The resin and components are applied to the labels in the same relative disposition as that of Figure 2. It will be appreciated that, when the mould cavity is defined by endless belts (as described in relation to Figure 2), the labels, components and resin are transported by the continuously moving mould. If the mould 11 is static, the labels, components and resin must be drawn through the mould with the resin setting and hardening as they move. Two pairs of opposing pinch rollers, 12 and 13 may be brought together periodically to pinch together and seal the "ends" of each label. The rollers are then withdrawn until the labels have moved, in the direction of the arrow, a sufficient distance for the next pair of labels to be adjacent the rollers, and so on.

## Claims

1. A method of manufacturing portable electronic tokens, such as smart cards, each token comprising one or more electronic components (1, 2) and data input/output means (4) encapsulated within a plastics body (8) and high tensile modulus members (6) disposed as skins on at least two opposing main faces of the body and having graphics thereon; which method is characterised by the steps of locating two high tensile members (6), each against a respective side of a mould (10), locating the components (1, 2) and data input/output means (4) between the members (6), injecting a reaction injection mouldable plastics material (8) into the mould (10, 11) such that it encapsulates the components (1, 2) and input/output means (4) and thus forms the plastics body (8) of the token but is prevented, by the members (6), from contacting the surface of the mould (10, 11), allowing the material (8) to harden, and, removing the token from the mould (10, 11).

2. A method as claimed in Claim 1 characterised in that the portions of the token are co-extruded.

3. A method as claimed in Claim 1 or Claim 2 characterised in that the mould (10) comprises two endless belts which are located to cooperate in use to form a continuously moving mould cavity.

4. A method as claimed in Claim 1 or Claim 2 characterised in that the high tensile members (6) are arranged in two continuous sheets and are transported through the moulds (10, 11) carrying the components (1, 2), input/output means (4) and plastics material (8); the individual tokens being subsequently separated after hardening.

5. A method as claimed in Claim 4 characterised in that, after the components (1, 2), input/output means (4), and plastics material (8) have been introduced between the members (6), the edges of the members (6) are sealed to form a sealed structure within which the plastics material (8) is allowed to harden.

6. A method as claimed in Claim 5 characterised in that pinch rollers are used to seal the edges of the members (6).

7. A method as claimed in any of the preceding claims characterised in that the graphics on the members (6) are provided on the inner surfaces (6a) of the members (6).

## Patentansprüche

1. Ein Verfahren der Herstellung tragbarer elektronischer Marken, wie kluger Karten, wobei jede Marke eine oder mehrere elektronische Komponenten (1, 2) umfaßt und ein Dateneingangs-/-ausgangsmittel (4), die innerhalb eines Kunststoffkörpers (8) eingekapselt sind, und Hochdehnmodulglieder (6) umfaßt, die als Häute auf Zumindest zwei sich gegenüberliegenden Hauptaußenflächen des Körpers angeordnet sind und darauf Graphiken tragen; wobei das Verfahren durch die Schritte gekennzeichnet ist, daß zwei Hochdehnglieder (6) räumlich angeordnet werden, jedes gegen eine jeweilige Seite einer Form (10), die Komponenten (1, 2) und das Dateneingangs-/-ausgangsmittel (4) zwischen den Gliedern (6) räumlich angeordnet werden, ein reaktionsspritzgießbares Kunststoffmaterial (8) in die Form (10, 11) so hinein eingespritzt wird, daß es die Komponenten (1, 2) und das Eingangs-/Ausgangsmittel (4) einkapselt und so den Kunststoffkörper (8) der Marke bildet, aber durch die Glieder (6) daran gehindert wird, die Oberfläche der Form (10, 11) zu berühren, dem Material (8) ermöglicht wird, zu härten, und dann die Marke aus der Form (10, 11) entfernt wird.

2. Ein Verfahren nach Anspruch 1, dadurch gekennzeichnet, daß die Teile der Marke koextrudiert werden.

3. Ein Verfahren nach Anspruch 1 oder 2, dadurch gekennzeichnet, daß die Form (10) zwei endlose Bänder umfaßt, welche räumlich angeordnet sind, um in der Verwendung zusammenzuwirken, um einen sich kontinuierlich bewegenden Formhohlraum zu bilden.

4. Ein Verfahren nach Anspruch 1 oder 2, dadurch gekennzeichnet, daß die Hochdehnglieder (6) in zwei durchgehenden Blättern angeordnet sind und durch die Formen (10, 11) transportiert werden, wobei sie die Komponenten (1, 2), das Eingangs-/Ausgangsmittel (4) und das Kunststoffmaterial (8) tragen; wobei die individuellen Marken nachfolgend nach der Härtung getrennt werden.

5. Ein Verfahren nach Anspruch 4, dadurch gekennzeichnet, daß, nachdem die Komponenten (1, 2), das Eingangs-/Ausgangsmittel (4) und das Kunststoffmaterial (8) zwischen die Glieder (6) eingeführt worden sind, die Ränder der Glieder (6) versiegelt werden, um einen versiegelten Aufbau zu bilden, innerhalb dessen dem Kunststoffmaterial (8) erlaubt wird, zu härten.

6. Ein Verfahren nach Anspruch 5, dadurch gekennzeichnet, daß Klemmwalzen verwendet werden, um die Ränder der Glieder (6) abzudichten.

7. Ein Verfahren nach einem der vorhergehenden Ansprüche, dadurch gekennzeichnet, daß die Graphiken auf den Gliedern (6) auf den inneren Oberflächen (6a) der Glieder (6) vorgesehen sind.

## Revendications

1. Procédé de fabrication de jetons électroniques portables, tels que des cartes à mémoire, chaque jeton comprenant un ou plusieurs composants électroniques (1, 2) et des dispositifs (4) encapsulés d'entrée/sortie de données dans un boîtier en plastique (8) et des pièces de facteur d'élasticité élevé (6) disposées en surface sur au moins deux des faces principales opposées du corps et ayant des graphismes sur celles-ci; lequel procédé est caractérisé par les étapes de positionnement de deux pièces de facteur élevé (6), chacune sur un côté respectif du moule (10) positionnant les composants (1, 2) et les dispositifs d'entrée/sortie de données (4) entre les pièces (6), d'injection d'une matière plastique de moulage réactif par injection (8) dans le moule (10, 11) de telle sorte qu'elle encapsule les composants (1, 2) et les dispositifs d'entrée/sortie (4) et ainsi forme le corps en plastique (8) du jeton mais les pièces (6) empêchent le contact avec la surface du moule (10, 11), permettant à la matière (8) de durcir, et de retirer le jeton du moule (10, 11).

2. Procédé selon la revendication 1 caractérisé en ce que les parties du jeton sont co-extrudés.

3. Procédé selon la revendication 1 ou la revendication 2 caractérisé en ce que le moule (10) comprend deux bandes sans fin qui sont placées pour coopérer lors de l'utilisation pour former une cavité de moulage se déplaçant en continu.

4. Procédé selon la revendication 1 ou la revendication 2 caractérisé en ce que les pièces de facteur de tension élevée (6) sont disposées en deux bandes continues et sont transportées par les moules (10, 11) comportant les composants (1, 2), les dispositifs d'entrée/sortie (4) et la matière plastique (8); les jetons individuels étant séparés séquentiellement après durcissement.

5. Procédé selon la revendication 4 caractérisé en ce que, après avoir introduit les composants (1, 2), les dispositifs d'entrée/sortie (4) et la matière plastique (8) entre les pièces (6), les bords des pièces (6) sont scellés pour former une structure scellée dans laquelle la matière plastique (8) peut durcir.

6. Procédé selon la revendication 5 caractérisé en ce que les rouleaux de pincement sont utilisés pour sceller les bords des pièces (6).

7. Procédé selon l'une quelconque des revendications précédentes, caractérisé en ce que les graphismes sur les pièces (6) sont placés sur les surfaces internes (6a) des pièces (6).
